# EUROPÄISCHE PATENTSCHRIFT

(11) **EP 0 463 016 B1**
(45) Veröffentlichungstag und Bekanntmachung des Hinweises auf die Patenterteilung: **25.08.1993**
(21) Anmeldenummer: 90904347.3
(22) Anmeldetag: 14.03.1990
(51) Int. Cl.: G03F 7/32

(54) **FLÜSSIGE ZUSAMMENSETZUNG FÜR DIE REINIGUNG EINER OBERFLÄCHE VON IHR ANHAFTENDEN POLYMEREN MATERIALIEN**
FLUID COMPOUND FOR CLEANING OFF POLYMERIC MATERIALS ADHERING TO A SURFACE
COMPOSITION LIQUIDE DE NETTOYAGE POUR ENLEVER DES MATERIAUX POLYMERES COLLES SUR UNE SURFACE

(30) Priorität: 17.03.1989 DE 3908764
(43) Veröffentlichungstag der Anmeldung: 02.01.1992
(73) Patentinhaber: BASF Aktiengesellschaft, 67063 Ludwigshafen (DE)
(72) Erfinder: TELSER, Thomas, D-6905 Schriesheim (DE); HUEMMER, Wolfgang, D-6703 Limburgerhof (DE); KOCH, Horst, D-6718 Gruenstadt (DE); KURTZ, Karl-Rudolf, D-6900 Heidelberg (DE); Werther, Heinz-Ulrich, W-6706 Wachenheim (DE); Schneider, Reinhard, W-6710 Frankenthal (DE)
(86) Internationale Anmeldenummer: EP9000405
(87) Internationale Veröffentlichungsnummer: WO9011344

## Beschreibung

Die vorliegende Erfindung betrifft ein Verfahren zur Herstellung photopolymerisierter flexographischer Reliefdruckplatten unter Verwendung einer flüssigen Zusammensetzung für die schonende, rückstandsfreie Reinigung einer Oberfläche von ihr anhaftenden, in organischen Lösungsmitteln löslichen oder quellbaren polymeren Materialien.

Flüssige Zusammensetzungen, mit deren Hilfe Oberflächen in schonender Weise von ihnen anhaftenden harz-, gummi- oder teerartigen Materialien befreit werden können, sind beispielsweise aus der US-A-3 933 674 bekannt. Diese bekannten flüssigen Zusammensetzungen bestehen in der Hauptsache aus einem deodorierten Kohlenwasserstofföl, einem ölartigen Zitrusdestillatoder-extrakt, Lanolin und eineroberflächenaktiven Verbindung. Flüssige Zusammensetzungen dieser Art greifen beim Reinigungsvorgang Farbstoff- oder Lackschichten nicht an und rufen auch keine Hautreizung hervor. Indessen läßt ihre Lösungskraft bei zahlreichen Anwendungszwecken zu wünschen übrig, so daß die rückstandsfreie Reinigung, insbesondere strukturierter Oberflächen, entweder nicht möglich ist oder daß hierfür eine zu lange Zeit und zu große Mengen der flüssigen Zusammensetzung benötigt werden.

Des weiteren sind flüssige Zusammensetzungen, welche Emulsionen vom Typ "ÖI-in-Wasser" sind und der Reinigung oder dem Wegwaschen polymerer Materialien von Oxidoberflächen dienen, bekannt. Beispielhaft sei auf die DE-A-11 66 002 verwiesen. Die dort beschriebene Emulsion enthält als disperse Phase ein wasserunlösliches organisches Lösungmittel, das in der kontinuierlichen wäßrigen Phase fein verteilt vorliegt. Diese Öl-in-Wasser -Emulsion enthält als wasserunlösliches organisches Lösungsmittel beispielsweise Xylol, Amylacetat und/oder Tetrachlorethylen, darüber hinaus kann sie Zusatzstoffe wie aliphatische Alkohole enthalten. Diese bekannte Öl-in-Wasser-Emulsion dient vor allem dem Entwickeln bildmäßig belichteter lichtempfindlicher lithographischer Flachdruckplatten. Hierbei werden bekanntermaßen die Bereiche der lichtempfindlichen Aufzeichnungsschicht der lithographischen Flachdruckplatte, welche nach der bildmäßigen Belichtung noch immer löslich sind, von der lithographischen Flachdruckplatte weggewaschen, wodurch die hydrophile Oxidoberfläche des Druckplattenträgers in diesen Bereichen vollständig freigelegt wird. Dieser Vorgang wird allgemein als Entwicklung bezeichnet.

Für die Entwicklung solcher lithographischer Flachdruckplatten und auch von Photoresisten, bei welcher hydrophile Oxidoberflächen freigelegt werden sollen, ist es essentiell, daß die hierfürverwendeten Emulsionen vom Typ "ÖI-in-Wasser" sind, damit die betreffenden hydrophilen Oberflächenbereiche benetzt werden können. Außerdem braucht die Lösungskraft der betreffenden Emulsionen nicht sonderlich hoch zu sein, weil die zu entwickelnden bildmäßig belichteten Aufzeichnungsschichten der lithographischen Flachdruckplatten und der Photoresiste im allgemeinen nur 0,1 bis 10 f..lm dick sind, so daß nur geringe Mengen polymeren Materials weggewaschen werden müssen. Die bekannten Öl-in-Wasser-Emulsionen lassen sich daher nicht uneingeschränkt zu anderen Zwecken verwenden. Insbesondere eignen sie sich nicht für die schonende, rückstandsfreie Reinigung einer strukturierten Oberfläche von großen Mengen an polymeren Materialien, insbesondere an Elastomeren, welche der Oberfläche anhaften.

Sowohl die EP-A-0 180 122 als auch die EP-A-0 034 788 richten sich auf Verfahren zur Herstellung von Flachdruck- oder Offsetdruckplatten. Im Gegensatz zu flexographischen Reliefdruckplatten haben diese Offsetdruckplatten keine Reliefschicht, sondern ihre druckende Oberfläche ist in hydrophobe, druckende Bereiche und hydrophile, nicht-druckende Bereiche unterteilt, weswegen sie auch als Flachdruckplatten bezeichnet werden. Die lichtempfindlichen Aufzeichnungsschichten der Vorläufer der Offset- oder Flachdruckplatten sind erheblich dünner als die photopolymerisierbaren lichtempfindlichen Aufzeichnungsschichten für die Herstellung flexographischer Reliefdruckplatten. Deswegen müssen bei der Herstellung von Offsetdruckplatten im Entwicklungsschritt erheblich geringere Mengen an Material weggewaschen werden, als dies bei der Entwicklung bildmäßig belichteter photopolymerisierbarer Aufzeichnungsschichten für die Herstellung von flexographischen Reliefdruckplatten der Fall ist. Dies hat zur Folge, daß sich das Verfahren zur Herstellung einer Offset- oder Flachdruckplatte hinsichtlich des Entwicklungsschritts deutlich von dem Verfahren zur Herstellung einer flexographischen Reliefdruckplatte unterscheidet.

Besonders kritisch ist die Auswahl flüssiger Zusammensetzungen oder Entwicklerlösungsmittel, welche bei der Herstellung photopolymerisierter Reliefdruckplatten, insbesondere flexographischer Reliefdruckplatten, verwendet werden sollen.

Bekanntermaßen wird bei der Herstellung einer solchen flexographischen Reliefdruckplatte deren in organischen Lösungsmitteln lösliche oder quellbare photopolymerisierbare reliefbildende Aufzeichnungsschicht bildmäßig belichtet, wonach die unbelichteten und daher nicht photopolymerisierten Bereiche der bildmäßig belichteten reliefbildenden Aufzeichnungsschicht mit einem Entwicklerlösungsmittel ausgewaschen oder entwickelt werden. Hierbei müssen zum einen größere Mengen polymeren Materials von der Oberfläche der zurückbleibenden photopolymerisierten Reliefschicht wegtransportiert werden, ohne daß hierbei irgendwelche Rückstände zurückbleiben, und zum anderen darf die photopolymerisierte Reliefschicht bei diesem Auswaschvorgang nicht angegriffen werden, da ansonsten die Qualität ihrer druckenden Oberfläche verschlechtert wird.

Bekanntermaßen hat man schon für die Herstellung photopolymerisierter flexographischer Reliefdruckplatten in der beschriebenen Weise chlorierte Kohlenwasserstoffe wie Tetrachlorethylen, aromatische Kohlenwasserstoffe wie Xylol oder Toluol, gesättigte cyclische und acyclische Kohlenwasserstoffe wie Octan oder Cyclohexan, ungesättigte cyclische Kohlenwasserstoffe wie Limonen, Petroleumdestillate, hydrierte Erdölfraktionen, Alkohole wie n-Butanol, Ketone wie Methylethylketon, Ester wie Ethylacetat, Ether wie Dioxan oder Tetrahydrofuran oder wäßrige Lösungsmittel wie Wasseroder Natronlauge verwendet. Hierbei hatsich die Auswahl des Entwicklerlösungsmittels in erster Linie nach den Löslichkeitseigenschaften des betreffenden auszuwaschenden polymeren, insbesondere elastomeren Materials gerichtet, wie bereits aus der US-A-2 760 863, der US-A-3 794 494 oder der US-A-4 294 908 hervorgeht. Indes wird bereits in der US-A-2 760 863 darauf hingewiesen, daß noch andere Auswahlkriterien maßgebend sind. So soll ein gutes Entwicklerlösungsmittel die zurückbleibende photopolymerisierte Reliefschicht der flexographischen Reliefdruckplatte nicht angreifen und dennoch eine hohe Lösungskraft aufweisen. Es soll eine hohe Verdampfungsrate haben, damit die photopolymerisierte Reliefschicht rasch getrocknet werden kann, wobei sich eine solche hohe Verdampfungsrate dann als nachteilig erweisen kann, wenn das Entwicklerlösungsmittel toxisch und/oder leicht brennbar ist. Demgemäß soll das Entwicklerlösungsmittel einen hohen Flammpunkt aufweisen oder am besten gar nicht brennbar sein, was dann wiederum nur durch die Verwendung toxischer und/oder hochsiedender Entwicklerlösungsmittel erfüllt werden kann, was jedoch in der betrieblichen Praxis die Handhabung, Wiederverwendung und Entsorgung dieser Entwicklerlösungsmittel erschwert oder unmöglich macht.

Derwesentliche Nachteil der bisher bekannten flüssigen Zusammensetzungen, welche ganz allgemein der Reinigung einer Oberfläche von ihr anhaftenden polymeren Materialien dienen, liegt bei dem vorstehend genannten Verwendungszweck insbesondere darin, daß die bekannten flüssigen Zusammensetzungen
- entweder die in organischen Lösungsmitteln löslichen polymeren Materialien nicht rückstandsfrei von der Oberfläche der photopolymerisierten Reliefschicht wegwaschen,
- oder daß sie zu aggressiv sind und daher die druckende Oberfläche der photopolymerisierten Reliefschicht oder die Reliefschicht insgesamt angreifen.

Die Nachteile der bislang bekannten flüssigen Zusammensetzungen fallen gerade bei diesem speziellen Verwendungszweck ganz besonders schwer ins Gewicht, weil sie hier im wörtlichen Sinn unmittelbar augenscheinlich werden. Ganz konkret haben die bislang bei der Herstellung von photopolymerisierten flexographischen Reliefdruckplatten verwendeten flüssigen Zusammensetzungen bzw. Entwicklerlösungsmittel die Bildung von Elastomerresten in der Form sogenannter "Tropfnasen" und von Runzeln und würmchenförmigen Strukturen, der sogenannten "Orangenhaut", auf oder in der druckenden Oberfläche der photopolymerisierten Reliefschicht zur Folge.

Aufgabe der vorliegenden Erfindung ist es, eine neue flüssige Zusammensetzung bereitzustellen, welche der Reinigung einer Oberfläche von ihr anhaftenden, in organischen Lösungsmitteln löslichen oder quellbaren polymeren Materialien dient und welche die Nachteile des Standes der Technik nicht mehr länger aufweist. Die neue flüssige Zusammensetzung soll die betreffende Oberfläche schonend reinigen ohne hierbei Rückstände zu hinterlassen. Insbesondere soll die neue flüssige Zusammensetzung bei ihrer verwendung als Entwicklerlösungsmittel bei der Herstellung photopolymerisierter flexographischer Reliefdruckplatten die vorstehend beschriebenen Nachteile nicht mehr aufweisen, sondern photopolymerisierte flexographische Reliefdruckplatten liefern, deren photopolymerisierte Reliefschicht eine einwandfreie druckende Oberfläche hat.

Überraschenderweise konnte diese Aufgabe durch die Zugabe großer Wassermengen zu organischen Lösungsmitteln gelöst werden. Im Hinblick auf den Stand der Technikund im Hinblick auf die jedermann bekannte Tatsache, daß zum Auflösen oder Anquellen polymerer Materialien, welche in organischen Lösungsmitteln löslich sind, eben diese organischen und keine wäßrigen Lösungsmittel verwendet werden, ist der aufgefundene Lösungsweg um so mehr überraschend.

Demgemäß handelt es sich bei dem Gegenstand der vorliegenden Erfindung um ein Verfahren zur Herstellung einer flexographischen Reliefdruckplatte, deren photopolymerisierte Reliefschicht eine einwandfreie druckende Oberfläche hat, durch
(a) bildmäßige Belichtung ihrer photopolymerisierbaren reliefbildenden Aufzeichnungsschicht, welche mindestens ein in organischen Lösungsmitteln lösliches oder quellbares Elastomer als Bindemittel, mindestens ein olefinisch ungesättigtes photopolymerisierbares Monomeres, das mit dem Elastomeren verträglich ist, und mindestens einen Photopolymerisationsinitiator enthält,
(b) Auswaschen (Entwickeln) der unbelichteten und daher nicht photopolymerisierten Bereiche der bildmäßig belichteten reliefbildenden Aufzeichnungsschicht mit einem Entwicklerlösungsmittel, wodurch die photopolymerisierte Reliefschicht resultiert,
   das dadurch gekennzeichnet ist, daß man hierbei als Entwicklerlösungsmittel eine Emulsion vom Typ "Wasser- in-Öl" verwendet, welche eine feindispergierte wäßrige Phase und eine kontinuierliche nicht brennbare oder schwer brennbare und/oder hochsiedende organische Phase im Volumenverhältnis von 90:10 bis 10:90 enthält.

Das erfindungsgemäß zu verwendende Entwicklerlösungsmittel isteineWasser-in-Öl-Emulsion, d.h., daß sie aus einer fein dispergierten wäßrigen Phase und aus einer kontinuierlichen organischen Phase besteht. Erfindungsgemäß liegt hierbei das Volumenverhältnis der wäßrigen Phase zur organischen Phase bei 90:10 bis 10:90. Es ist durchaus möglich, dieses Volumenverhältnis größer, beispielsweise 95:5, oder kleiner, beispielsweise 5:95 zu wählen. Indes kommen erfindungsgemäß zu verwendende Wasserin-ÖI-Emulsionen, welche solche Volumenverhältnisse aufweisen, entweder nur für ganz spezielle Verwendungszwecke in Betracht oder die besonderen Vorteile stellen sich nicht immer in zuverlässiger Weise ein. Demnach handelt es sich bei dem Volumenverhältnis von 90:10 bis 10:90 um den optimalen Bereich, innerhalb dessen das Volumenverhältnis von wäßriger Phase zur organischen Phase in vorteilhafter Weise gezielt eingestellt und dem betreffenden Verwendungszweck angepaßt werden kann.

Innerhalb dieses optimalen Bereichs ist derjenige von 70:30 bis 30:70 besonders vorteilhaft, weil die erfindungsgemäß einzusetzenden Wasser-in-Öl-Emulsionen, welche ein Volumenverhältnis in diesem Bereich aufweisen, eine besonders gute und dennoch schonende Reinigungswirkung haben.

Ganz besonders bevorzugt werden solche Wasser-in-Öl-Emulsionen verwendet, welche ein Volumenverhältnis im Bereich von 60:40 bis 40:60 aufweisen. Diese Wasser-in-Öl-Emulsionen lassen sich nämlich besonders vorzüglich für die schonende, rückstandsfreie Reinigung von Oberflächen der unterschiedlichsten Art verwenden. Insbesondere eignen sie sich hervorragend als Entwicklerlösungsmittel bei der Herstellung photopolymerisierter flexographischer Reliefdruckplatten.

Der eine wesentliche Bestandteil der erfindungsgemäß einzusetzenden Wasser-in-Öl-Emulsion ist die fein dispergierte wäßrige Phase, welche destilliertes oder entsalztes Wasser oder normales Leitungswasser mit Trinkwasserqualität enthält. Vorzugsweise handelt es sich um normales Leitungswasser.

Hierbei kann die wäßrige Phase noch geeignete Zusatzstoffe gelöst enthalten.

Beispiele geeigneter Zusatzstoffe sind wasserlösliche organische und anorganische Säuren oder Basen, organische und anorganische saure und basische Salze, Komplexbildner und geruchsverbessernde Stoffe. Diese Zusatzstoffe werden in solche Mengen verwendet, daß sie die Bildung und die Sta- ; bilität der erfindungsgemäß einzusetzenden Wasser-in-Öl-Emulsion nicht beeinträchtigen.

Der andere wesentliche Bestandteil der erfindungsgemäß zu verwendenden Wasser-in-Öl-Emulsion ist die kontinuierliche organische Phase, welche als solche nicht brennbar oder schwer brennbar und/ oder hochsiedend ist. Hierbei bedeutet "nicht brennbar", daß die betreffende organische Phase für sich selbst gesehen unter dem Sauerstoffpartialdruck der Luft die Verbrennung nicht aufrecht erhält. "Schwer brennbar" bedeutet, daß die organische Phase für sich selbst gesehen einen Flammpunkt nach DIN 51 755 oder DIN 51 758 oberhalb 45, vorzugsweise 50 und insbesondere 60°C hat. "Hochsiedend" bedeutet, daß die betreffende organische Phase einen Siedepunkt oder Siedebereich oberhalb 120, vorzugsweise 150 und insbesondere 160°C hat.

Geeignete organische Phasen bestehen in der Hauptsache aus chlorierten Kohlenwasserstoffen, gesättigten und/oder ungesättigten cyclischen Kohlenwasserstoffen, gesättigten und/oder ungesättigten acyclischen Kohlenwasserstoffen, Petroleumdestillaten, hydrierten Erdölfraktionen und/oder deren Gemische, welche allesamt jeweils für sich selbst gesehen bereits nicht brennbar oder schwer brennbar und/oder hochsiedend sind.

Beispiele geeigneter erfindungsgemäß zu verwendender chlorierter Kohlenwasserstoffe sind 1,1,1-Trichlorethan und Tetrachlorethylen, von denen Tetrachlorethylen bevorzugt ist.

Beispiele geeigneter erfindungsgemäß zu verwendender aromatischer Kohlenwasserstoffe sind Xyioi, die trimethylsubstituierten Benzole, Ethylbenzyl, die diethylsubstituierten Benzole, Cumol, n-Butylbenzol, Tetrahydronaphthalin, n-Pentylbenzol und n-Hexylbenzol.

Beispiele geeigneter erfindungsgemäß zu verwendender gesättigter cyclischer Kohlenwasserstoffe sind Cyclooctan, Dekalin, Hexylcyclopentan und Hexylcyclohexan.

Beispiele geeigneter erfindungsgemäß zu verwendender ungesättigter cyclischer Kohlenwasserstoffe sind Monoterpene wie p-Menthan, Borneol, Menthon, D- und L-Limonen, a-Terpineol, a-Terpinen, y-Terpinen, Terpinolen, a-, β- und o-Pinen und Citronellol.

Beispiele geeigneter erfindungsgemäß zu verwendender gesättigter acyclischer Kohlenwasserstoffe sind Octan, Nonan, Decan, Undecan, Dodecan, Tri- decan und Tetradecan.

Beispiele geeigneter erfindungsgemäß zu verwendender ungesättigter acyclischer Kohlenwasserstoffe sind Octen, Nonen, Decen und Undecen.

Beispiele geeigneter erfindungsgemäß zu verwendender Petroleumdestillate und hydrierter Erdölfraktionen sind Testbenzine, welche einen Siedebereich von 150 bis 190°C, einen Flammpunkt von 40 bis 50°C, einen Aromatengehalt von 25 %, einen Gehalt an naphthenischen Kohlenwasserstoffen von 10 % und einen Gehalt an Paraffinen von 65 % aufweisen; Testbenzine, welche einen Siedebereich von 180 bis 220°C, einen Flammpunkt von 60 bis 70°C, einen Aromatengehalt von 25 %, einen Gehalt an naphthenischen Kohlenwasserstoffen von 10 % und einen Paraffingehalt von 65 % aufweisen; entaromatisierte Testbenzine, welche einen Siedebereich von 180 bis 220°C, einen Flammpunkt von oberhalb 60°C, einen Aromatengehaltvon kleiner 1 %, einen Gehalt an naphthenischen Kohlenwasserstoffen von 35 % und einen Gehalt von Paraffinen von größer 64 % aufweisen; synthetische Isoparaffine, welche einen Siedebereich von 180 bis 220°C, einen Flammpunkt von über 65°C und einen Gehalt an Paraffinen von größer als 99 % aufweisen; Testbenzine, welche einen Siedebereich von 170 bis260°C, einen Flammpunkt oberhalb 60°C, einen Aromatengehalt von 13 %, einen Gehalt an naphthenischen Kohlenwasserstoffen von 10 % und einen Paraffingehalt von 77 % aufweisen; n-ParaffinFraktionen, welche einen Siedebereich von 180 bis 230°C, einen Flammpunkt oberhalb 55°C, einen Aromatengehalt kleiner als 0,1 % und einen Paraffingehalt von größer 99,9 % aufweisen; und hydrierte Mineralöle, welche einen Siedebereich von 220 bis 260°C, einen Flammpunkt von 90°C und höher, einen Aromatengehalt von 3 %, einen Gehalt an naphthenischen Kohlenwasserstoffen von 31 % und einen Paraffingehalt von 66 % aufweisen.

Bevorzugt als organische Phase sind auch hydrierte Erdölfraktionen mit einem Flammpunkt > 45_{°}C und einem Siedebereich oberhalb 160°C.

Beispiele weiterer geeigneter erfindungsgemäß zu verwendender organischer Lösungsmittel, welche als organische Phase der erfindungsgemäßen flüssigen Zusammensetzung in Betracht kommen, sind schwer brennbare und/oder hochsiedende Ether, Ester und Ketone, wie Dibutylether, Dipentylether, Dihexylether, Hexylacetat, Heptylacetat, Octylacetat, Nonylacetat, Decylacetat, Dibutyladipat, Diethylsebacat, Dibutylsebacat, Diethylphthalat, Dibutylphthalat, Diethylsuccinat und Gemische langkettiger Alkylester mit Alkylgruppen unterschiedlicher Kettenlänge sowie Ethylbutylketon und Dibutylketon.

Von den genannten Beispielen geeigneter erfindungsgemäß zu verwendender organischer Phasen sind Tetrachlorethylen, die entaromatisierten Testbenzine, die synthetischen Isoparaffine, die n-Paraffinfraktionen, die hydrierten Mineralöle, die cyclischen Monoterpene und die langkettigen Alkylester mit Alkylgruppen unterschiedlicher Kettenlänge besonders vorteilhaft.

Außerdem kann die erfindungsgemäß zu verwendende organische Phase geeignete geruchsverbessernde Stoffe in einer solchen Menge gelöst enthalten, daß die Bildung und die Stabilität der erfindungsgemäßen Wasser-in-Öl-Emulsion nicht beeinträchtigt werden.

Die erfindungsgemäß einzusetzende Wasser-in-Öl-Emulsion kann außer den beiden wesentlichen Bestandteilen 0,1 bis 20 Vol.% mindestens eines Alkohols enthalten.

Beispiele geeigneter Alkohole sind n-Butanol, n-Pentanol, n-Hexanol, Cyclohexanol, n-Heptanol, n-Octanol, n-Decanol, Laurylalkohol, 3-Methyl-3 -methoxybutanol, Benzylalkohol oder 2,3,5-Trimethylhexanol.

Außerdem kann die erfindungsgemäß zu verwendende Wasser-in-Öl-Emulsion 0,001 bis 10 Vol.%, vorzugsweise 0,01 bis 5 Vol.% und insbesondere 0,1 bis 2 Vol.% mindestens einer oberflächenaktiven Verbindung enthalten.

Beispiele geeigneter oberflächenaktiver Substanzen sind Emulgatoren wie sie üblicherweise für die Stabilisierung von Wasser-in-Öl-Emulsionen verwendet werden, wie Kondensationsprodukte von Fettaminen mit Ethylenoxid, Kondensationsprodukte von Alkoholen mit langkettigen Fettsäuren, und Kondensationsprodukte von Aminoalkoholen mit langkettigen Fettsäuren. Beispiele besonders gut geeigneter Emulgatoren sind Cremopho@ WOCE 5115 der Fa. BASF (Addukt aus Glycerin, Epichlorhydrin, Oleylalkohol und Ethylenoxid), Span@ 60 der Fa. ICI (Sorbitanmonostearat) und Emulan® FN der Fa. BASF (Addukt aus einem Aminoalkohol und Oleinsäure).

Methodisch bietet die Herstellung der erfindungsgemäßen flüssigen Zusammensetzung keine Besonderheiten, sondern erfolgt durch das Zusammengeben der gewünschten Bestandteile in den gewünschten Mengen unter intensiver Durchmischung durch Rühren, Versprühen oder Umpumpen. Hierbei ist es von Vorteil, die betreffenden Bestandteile zusammen in einem Vorratsbehälter aufzubewahren und hieraus die erfindungsgemäße flüssige Zusammensetzung unmittelbar vor ihrer Verwendung herzustellen.

Die erfindungsgemäß zu verwendende Wasser-in-ÖI-Emulsion weist besondere unerwartete Vorteile auf.

So ist sie weitgehend oder völlig geruchlos oder sie weist einen im Vergleich zur reinen organischen Phase deutlich geringeren oder erheblich angenehmeren Geruch auf. Sofern keine nicht brennbare organische Phase wie beispielsweise Tetrachlorethylen verwendet wird, ist ihr Flammpunkt im Vergleich zur reinen, ohnedies schon schwer brennbaren organischen Phase deutlich erhöht, weswegen für ihre Anwendung keine explosionsgeschützten Anlagen notwendig sind. Für den Fall, daß eine vergleichsweise stark toxische organische Phase in der erfindungsgemäß zu verwendenden Wasserin-ÖI-Emulsion verwendet wird, kann die Emission der organischen Phase durch einen geringeren technischen Aufwand unterdrückt werden, als dies bei der Verwendung der reinen organischen Phase möglich ist, so daß die von den Gesetzgebern vorgeschriebenen Maximalwerte für die Emission der betreffenden reinen organischen Phase signifikant unterschritten werden, weswegen die erfindungsgemäße Verwendung der betreffenden Wasser-in-Öl-Emulsion auch aus sicherheitstechnischen, ökologischen und gesundheitlichen Gründen von Vorteil ist. Deshalb können auch die betreffenden Wasser-in-Öl-Emulsionen bei deutlich höheren Temperaturen verwendet werden, was ihre ohnehin schon hohe Lösungskraft noch weiter steigert.

Darüber hinaus ist die erfindungsgemäß zu verwendende Wasser-in-Öl-Emulsion ein hervorragendes Reinigungsmittel, durch welches sich Oberflächen der unterschiedlichsten Art von ihnen anhaftenden, in organischen Lösungsmitteln löslichen oder quellbaren polymeren Materialien befreien lassen, ohne daß hierbei Rückstände verbleiben oder die Oberflächen geschäd igt werden. Demgemäß lassen sich Keramik-, Glas-, Metall- und Kunststoffoberflächen, selbst wenn sie strukturiert sind, mit Hilfe der erfindungsgemäßen Wasser- in-ÖI-Emulsion hervorragend reinigen. Hierbei lassen sich insbesondere Kunststoffoberflächen, wie sie beispielsweise in photopolymerisierten Reliefschichten flexographischer Reliefdruckplatten vorliegen, rasch, schonend und rückstandsfrei von anhaftenden elastomeren Materialien befreien.

Darüber hinaus kann die verbrauchte erfindungsgemäße Wasser-in-Öl-Emulsion, selbst wenn sie eine besonders hochsiedende organische Phase enthält, in einfacher Weise durch Destillation bei Normaldruck gereinigt und im Anschlup daran wiederverwendet werden.

All diese bereits genannten und weitere besondere unerwartete Vorteile der erfindungsgemäßen Wasser- in-ÖI-Emulsion werden bei ihrer Verwendung als Entwicklerlösungsmittel bei der Herstellung photopolymerisierter flexographischer Reliefdruckplatten ganz besonders deutlich.

Bekanntermaßen wird eine photopolymerisierte flexographische Reliefdruckplatte aus einem lichtempfindlichen Aufzeichnungselement hergestellt, welches einen dimensionsstabilen Träger und eine photopolymerisierbare reliefbildende Aufzeichnungsschicht enthält. Die photopolymerisierbare reliefbildende Aufzeichnungsschicht selbst enthält üblicherweise mindestens ein in organischen Lösungsmitteln lösliches oder quellbares Elastomer als Bindemittel, mindestens ein olefinisch ungesättigtes photopolymerisierbares Monomeres, das mit dem oder den Elastomeren verträglich ist, und mindestens einen Photopolymerisationsinitiator. Wenn die aus dem lichtempfindlichen Aufzeichnungselement herzustellende photopolymerisierte flexographische Reliefdruckplatte für den hochqualitativen Rasterflexodruck verwendet werden soll, ist die photopolymerisierbare reliefbildende Aufzeichnungsschicht im allgemeinen bis zu 0,7 mm dick. Wenn die betreffende photopolymerisierte flexographische Reliefdruckplatte dagegen im Kartonagen- und Well pappendruck verwendet werden soll, kann die Dicke der photopolymerisierbaren reliefbildenden Aufzeichnungsschicht bei bis zu 7 mm liegen. Im allgemeinen werden als Bindemittel Elastomere wie Vinylaromat/Alkadien-Blockmischpolymerisate (Styrol-Isopren-Styrol, Styrol-Butadien-Styrol, Styrol-Isopren-Styrol/Butadien, etc.) Alkadien/ Acrylnitril-Copolymerisate (Butadien-Acrylnitril), Fluorkautschuke (Vinylidenchlorid-Hexafluorpropylen-Copolymerisate), Naturkautschuk, Silikonpolymerisate und Polysulfidkautschuke verwendet.

Beispiele geeigneter lichtempfindlicher Aufzeichnungselemente für die Herstellung photopolymerisierter flexographischer Reliefdruckplatten sind aus der EP-B-0 084 851, der US-A-4 323 636, der US-A-4 369 246, der US-A-4 323 637, der EP-B-0 133 265, der US-A-4 162 919, der US-A-4 320 188 (DE-A-29 42 183), der EP-B-0 027 612 und der DE-A-29 39 989 bekannt.

Die photopolymerisierbare reliefbildende Aufzeichnungsschicht der lichtempfindlichen Aufzeichnungselemente wird bekanntermaßen mit aktinischem Licht bildmäßig belichtet, wodurch ihre belichteten Bereiche durch Photopolymerisation vernetzt und daher unlöslich werden, wogegen ihre unbelichteten und daher nicht photopolymerisierten Bereiche in organischen Lösungsmitteln löslich bleiben. Diese Bereiche der bildmäßig belichteten reliefbildenden Aufzeichnungsschicht können daher mit einem Entwicklerlösungsmittel ausgewaschen werden, wodurch die photopolymerisierte Reliefschicht der flexographischen Reliefdruckplatte resultiert. Weil hierbei große Mengen elastomeren Materials rasch, schonend und rückstandsfrei weggewaschen werden müssen, ist das Auswaschen oder Entwickeln der bildmäßig belichteten reliefbildenden Aufzeichnungsschicht besonders kritisch.

Üblicherweise wird das Entwickeln in den bekannten Sprüh-, Bürsten- und Reibewaschern bei Temperaturen von 20 bis 50°C durchgeführt. Dabei zeigt es sich, daß die für eine bestimmte Auswaschtiefe notwendige Auswaschzeit ; bei der erfindungsgemäßen Verwendung der Wasser-in-ÖI-Emulsion trotz ihres hohen Wassergehaltes entweder gar nicht oder nur unwesentlich höher ist als im Falle der Verwendung der reinen organischen Phase, daß aber die Lösungsmittelaufnahme der zurückbleibenden photopolymerisierten Reliefschicht in vielen Fällen verringert wird. Dadurch verbessert sich die überwaschresistenz der photopolymerisierten Reliefschicht ganz erheblich, d.h. auch wenn die für eine bestimmte Relieftiefe notwendige Auswaschzeit überschritten wird, werden fehlerfreie Reliefstrukturen erhalten. Dies ist vor allem für photopolymerisierte flexographische Reliefdruckplatten von Bedeutung, welche für den hochqualitativen Rasterflexodruck verwendet werden.

Auch die Ausbruchstabilität der Reliefstrukturen wird durch die erfindungsgemäße Verwendung der Wasser-in-Öl-Emulsion erheblich verbessert. Dies ist von ganz besonderer Bedeutung bei einer dicken weichelastischen flexographischen Reliefdruckplatte mit tiefem Relief, welche beispielsweise im Kartonagen- und Wellpappendruck eingesetzt wird.

Ein weiterer überraschender Vorteil, welcher sich aus der erfindungsgemäßen Verwendung der Wasser- in-ÖI-Emulsion als Entwicklerlösungsmittel ergibt, betrifft die druckende Oberfläche der photopolymerisierten Reliefschicht der flexographischen Reliefdruckplatte. Diese druckende Oberfläche ist von einwandfreier Beschaffenheit und weist keine unerwünschten Oberflächenstrukturen in der Form von Runzeln oder Würmchen, d.h. die sogenannte Orangenhaut, auf, sondern sie ist gleichmäßig glatt oder mattiert. Außerdem bleiben keine Rückstände an elastomerem Material in der Form von sogenannten Tropfnasen auf der druckenden Oberfläche zurück, was im Hinblick auf die Qualität der Druckerzeugnisse, welche mit der betreffenden flexographischen Reliefdruckplatte hergestellt werden, ein nicht zu unterschätzender Vorteil ist.

Ein weiterer überraschender Vorteil ist die Tatsache, daß sich aus der erfindungsgemäßen Verwendung der Wasser-in-Öl-Emulsion als Entwicklerlösungsmittel keine verlängerten Trocknungszeiten nach der Entwicklung ergeben.

Vorteilhaft ist ferner, daß die Entwicklung mit Hilfe der erfindungsgemäß zu verwendenden flüssigen Wasser-in-Öl-Emulsion in nicht explosionsgeschützten Auswaschgeräten durchgeführt werden kann. Außerdem kann die Absaugung der Auswaschgeräte wegen des geringen Eigengeruchs und/oder der deutlich verringerten Toxizität der erfindungsgemäß zu verwendenden flüssigen Wasser-in-Öl-Emulsion stark reduziert werden.

Beispiele und Vergleichsversuche

Für die Beispiele und Vergleichsversuche wurden die folgenden flexographischen Reliefdruckplatten verwendet:
Flexographische Reliefdruckplatte 1:
Die flexographische Reliefdruckplatte 1 wies eine 125 µm starke, mit einem Polyurethanhaftlack beschichtete Polyethylenterephthalat-Folie als dimensionsstabilem Träger auf. Ihre photopolymerisierbare reliefbildende Aufzeichnungsschicht war 2700 µm dick und bestand aus
   87,592 Gew.-% des Styrol/Isopren/(Styrol-Butadien)-Dreiblockmischpolymerisats gemäß der EP-A-0 027 612,
5 Gew.-% eines Paraffinöls
5 Gew.-% Hexan-1,6-diol-diacrylat,
1,2 Gew.-% Benzildimethylacetal,
1,2 Gew.-% 2,6-Di-tert.-butyl-p-kresol und
0,008 Gew.-% des Farbstoffs Solvent Black (C.I. 26 150).

Diese photopolymerisierbare reliefbildende Aufzeichnungsschicht (B) war mit einer 5 µm starken Deckschicht aus einem Polyamid (Macromelt® 6900 der Fa. Henkel AG) bedeckt.

Flexographische Reliefdruckplatte 2:
Die flexographische Reliefdruckplatte 2 wies den in der US-A-3 990 897 (DE-A-24 44 118) beschriebenen Mehrschichtenaufbau auf. Bei diesem Mehrschichtenaufbau wurde eine 2000 µm starke, weichelastische Unterschicht verwendet, welche durch vollflächiges Belichten einer photopolymerisierbaren Schicht der gleichen Zusammensetzung wie die nachstehend beschriebene photopolymerisierbare reliefbildende Aufzeichnungsschicht hergestellt worden war. Diese weichelastische Unterschicht war mit einer 125 µm starken Polyethylenterephthalat-Folie als Zwischenschicht haftfest verbunden. Beide Schichten bildeten zusammen den dimensionsstabilen Träger derflexographischen Reliefdruckplatte. Auf ihrerfreien Seite war die Zwischenschicht mit einer 700 µm starken photopolymerisierbaren reliefbildenden Aufzeichnungsschicht bedeckt. DieAufzeichnungsschicht bestand aus
93,596 Gew.-% des Dreiblockmischpolymerisats der flexographischen Reliefdruckplatte 1, 5 Gew.-% Hexan-1,6-diol-diacrylat,
0,4 Gew.-% Benzildimethylacetal,
1,0 Gew.-% 2,6-Di-tert.-butyl-p-kresol und
0,004 Gew.-% des Farbstoffs Solvent Black (C.I. 26 150).

Diese photopolymerisierbare reliefbildende Aufzeichnungsschicht war mit der bei der flexographischen Reliefdruckplatte 1 beschriebenen Deckschicht bedeckt.

Flexographische Reliefdruckplatte 3:
Die flexographische Reliefdruckplatte 3 war sowohl in ihrem Aufbau und in ihrer stofflichen Zusammensetzung identisch mit der flexographischen Reliefdruckplatte des Beispiels 1 der EP-B-0 084 851.

Die flexographischen Reliefdruckplatten 1 und 3 wurden von ihrer Rückseite her in einem Röhrenbelichter vollflächig mit aktinischem Licht belichtet. Hiernach wurden die flexographischen Reliefdruckplatten 1, 2 und 3 durch eine auf ihre Deckschichten aufgelegte Standard-Negativvorlage hindurch während 10 Minuten bildmäßig mit aktinischem Licht belichtet.

Im Anschluß an die bildmäßige Belichtung wurden die flexographischen Reliefdruckplatten 1, 2 und 3, sofern nichts anderes angegeben wird, bei Raumtemperatur in Trommelbürstenwaschern von ca. 60 I Fassungsvermögen sowohl mit erfindungsgemäß zu verwendenden Wasser-in-Öl-Emulsionen als auch nicht erfindungsgemäßen flüssigen Zusammensetzungen ausgewaschen, d.h. entwickelt. Bei diesem Entwicklungsschritt wurden die nicht belichteten und daher nach wie vor in organischen Lösungsmitteln löslichen oder quellbaren Bereiche der bildmäßig belichteten reliefbildenden Aufzeichnungsschichten weggewaschen, was die Bildung von photopolymerisierten Reliefschichten, d.h. fein strukturierten Kunststoffoberflächen, zur Folge hatte.

Hiernach wurden die gegebenenfalls auf der Oberfläche der photopolymerisierten flexographischen Reliefdruckplatten 1, 2 und 3 vorhandenen Wasserreste mit Hilfe organischer Lösungsmittel weggewaschen. Im Anschluß daran wurden die photopolymerisierten flexographischen Reliefdruckplatten 1, und 3 in einem Umlufttrockenschrank bei 65°C während 2 Stunden getrocknet und nach einer Ruhezeit von ca. 12 Stunden zur Entklebung ihrer druckenden Oberfläche einer üblichen und bekannten Nachbehandlung mit einer wäßrigen Bromlösung unterzogen und danach nochmals während 10 Minuten mit aktinischem Licht nachbelichtet.

In dieser Art und Weise wurden jeweils soviele photopolymerisierte flexographische Reliefdruckplatten 1, 2 oder 3 hergestellt, daß der Feststoffgehalt der jeweils verwendeten erfindungsgemäßen und nicht erfindungsgemäßen flüssigen Zusammensetzungen (Entwicklerlösungsmittel) in den Trommelbürstenwaschern 5 Gew.-%, bezogen auf die flüssige Zusammensetzung, erreichte. Hierbei wurden vor jedem einzelnen separaten Entwicklungsvorgang die jeweils verwendeten erfindungsgemäßen und nicht erfindungsgemäßen flüssigen Zusammensetzungen während 1 Minute in den Trommelbürstenwaschern umgepumpt.

Bei der Entwicklung wurde die Emission in kg/h der erfindungsgemäßen und nicht erfindungsgemäßen flüssigen Zusammensetzungen aus den Trommelbürstenwaschern bestimmt. Hierzu wurde die Beladung der Abluft aus den Trommelbürstenwaschern in üblicher und bekannter Weise gemessen und mit der abgesaugten Luftmenge pro Stunde multipliziert.

Die gebrauchten erfindungsgemäßen und nicht erfindungsgemäßen flüssigen Zusammensetzungen wurden, sofern dies möglich war, unter Normaldruck destillativ aufgearbeitet und gegebenenfalls nach Ergänzung der organische Phase wiederverwendet.

Die Oberflächenqualität der in der vorstehend beschriebenen allgemeinen Verfahrensweise hergestellten photopolymerisierten flexographischen Reliefdruckplatten 1, 2 und 3 wurde visuell bestimmt.

Für die Druckversuche wurden die photopolymerisierten flexographischen Reliefdruckplatten 1, 2 und 3 auf Druckzylinder aufgespannt und in einem Flexodruckwerk unter Verwendung üblicher und bekannter Flexodruckfarben für den Flexoendlosdruck verwendet.

In den folgenden Beispielen werden die erfindungsgemäß zu verwendenden Wasser-in-ÖI-Emulsionen als "erfindungsgemäße flüssige Zusammensetzung" bezeichnet.

### Beispiel 1

Verwendung einer erfindungsgemäßen flüssigen Zusammensetzung für die Herstellung photopolymerisierter flexographischer Reliefdruckplatten 1

Für die Herstellung photopolymerisierter flexographischer Reliefdruckplatten 1 wurde eine erfindungsgemäße flüssige Zusammensetzung aus
- 24 I des entaromatisierten Testbenzins EXXSOL® D 60 der Fa. Esso (Siedebereich 186 bis 217°C;
Flammpunkt nach DIN 51 755 61°C; geruchlos; Aromatengehalt <1 %; Gehalt an naphthenischen Kohlenwasserstoffen 35 %; Paraffingehalt >64 %),
- 6 I n-Butanol und
- 30 I Leitungswasser
   verwendet. Diese zweiphasige Mischung wurde während 1 Minute in dem Trommelbürstenwascher umgepumpt, wodurch die erfindungsgemäß zu verwendende Wasser-in-Öl-Emulsion resultierte. Da der Flammpunkt nach DIN 51 755 dererfindungsgemäßen flüssigen Zusammensetzung bei 39°C lag, war keine spezielle Explosionsschutzausrüstung für den verwendeten Trommelbürstenwascher erforderlich. Die Entwicklungs- bzw. Auswaschzeit für jede photopolymerisierte flexographische Reliefdruckplatte 1 lag bei 10 Minuten.

Nach der Entwicklung wurde jede photopolymerisierte flexographische Reliefdruckplatte 1 zur Entfernung von Wassertröpfchen mit dem reinen entaromatisierten Testbenzin abgespült.

Die in dieser Weise hergestellten photopolymerisierten flexographischen Reliefdruckplatten I wiesen hervorragend ausgebildete photopolymerisierte Reliefschichten einer Relieftiefe von 1000 µm auf. In den Volltonflächen der photopolymerisierten Reliefschichten wurden weder Polymerreste in der Form von Tropfnasen noch die typische Orangenhaut gefunden. Die photopolymerisierten Reliefschichten waren fehlerfrei und geruchlos. Beim Drucken lieferten die in dieser Weise hergestellten photopolymerisierten flexographischen Reliefdruckplatten 1 hervorragende Druckerzeugnisse in sehr hoher Auflage.

Auch hinsichtlich der Emission und der Wiederaufarbeitung wies die verwendete erfindungsgemäße flüssige Zusammensetzung Vorteile auf.

So lag die Emission nur bei 0,3 kg/h. Während der Entwicklung war der ansonsten stark störende Geruch des n-Butanols deutlich vermindert. Die gebrauchte erfindungsgemäße flüssige Zusammensetzung des Feststoffgehalts von 5 Gew.-% konnte durch Destillation unter Normaldruck bei übergangstemperaturen zwischen 90 und 110°C wiederaufgearbeitet werden. Hierbei wurden 54 der erfindungsgemäßen flüssigen Zusammensetzung zurückgewonnen. Nach Ergänzung der restlichen 6 I entaromatisierten Testbenzins war die erfindungsgemäße flüssige Zusammensetzung wieder gebrauchsfertig.

### Vergleichsversuch 1

Die Verwendung einer nicht erfindungsgemäßen flüssigen Zusammensetzung für die Herstellung photopolymerisierter flexographischer Reliefdruckplatten 1

Beispiel 1 wurde wiederholt, nur daß anstelle der erfindungsgemäßen flüssigen Zusammensetzung die nicht erfindungsgemäße flüssige Zusammensetzung aus 40 I Tetrachlorethylen und 10 I n-Butanol verwendet wurde. Während der Entwicklung wurden zugleich der unangenehme süßliche Geruch des Tetrachlorethylens und der störende Geruch des n-Butanols intensiv wahrgenommen. Außerdem war die Emission an Tetrachlorethylen sehr hoch, so daß die allgemein gültigen Emissionsgrenzwerte um eine Größenordnung überschritten wurden. Die in dieser Weise hergestellten photopolymerisierten flexographischen Reliefdruckplatten 1 wiesen photopolymerisierte Reliefschichten einer Relieftiefe von 1200 µm auf. An deren Volltonflächen wurden zwar keine Polymerreste in der Form von Tropfnasen gefunden, indes waren würmchenförmige Strukturen und Runzeln (Orangenhaut) vorhanden.

### Vergleichsversuch 2

Verwendung einer nicht erfindungsgemäßen flüssigen Zusammensetzung für die Herstellung photopolymerisierter flexographischer Reliefdruckplatten 1

Beispiel 1 wurde mit der nicht erfindungsgemäßen flüssigen Zusammensetzung aus 40 I des entaromatisierten Testbenzins des Beispiels 1 und 10 I n-Butanol wiederholt. Der Flammpunkt nach DIN 51 755 dieser nicht erfindungsgemäßen flüssigen Zusammensetzung lag bei 33°C, was bereits die Verwendung einer Explosionsschutzausrüstung für den Trommelbürstenwascher notwendig machte. Während der Entwicklung wurde der Geruch des n-Butanols als ausgesprochen störend empfunden.

Es wurden photopolymerisierte flexographische Reliefdruckplatten 1 erhalten, deren photopolymerisierte Reliefschichten eine Relieftiefe von 1000 µm hatten. Auf der Oberfläche der einzelnen photopolymerisierten Reliefschichten wurden mit zunehmendem Feststoffgehalt der flüssigen Zusammensetzung vermehrt Polymerablagerungen in der Form von Tropfnasen gefunden.

Die gebrauchte nicht erfindungsgemäße flüssige Zusammensetzung konnte bei Atmosphärendruck nicht destillativ wiederaufgearbeitet werden.

### Beispiel 2

Die Verwendung einer erfindungsgemäßen flüssigen Zusammensetzung für die Herstellung photopolymerisierter flexographischer Reliefdruckplatten 1

Beispiel 1 wurde wiederholt, nur daß der erfindungsgemäßen flüssigen Zusammensetzung noch 600 g des Emulgators Cremopho® WOCE 5115 der Fa. BASF (Addukt aus Glycerin, Epichlorhydrin, Oleylalkohol und Ethylenoxid) hinzugefügt wurde. Nach dem Umpumpen wurde eine fein verteilte Wasser-in-Öl-Emulsion erhalten, welche sich erst nach ca. 20 Minuten wieder in zwei Phasen auftrennte. Sie wies die gleichen hervorragenden anwendungstechnischen Eigenschaften wie die Emulsion des Beispiels 1 auf und lieferte gleich gute photopolymerisierte flexographische Reliefdruckplatten 1.

### Vergleichsversuch 3

Die Verwendung einer nicht erfindungsgemäßen flüssigen Zusammensetzung für die Herstellung photopolymerisierter flexographischer Reliefdruckplatten 1

Beispiel 2 wurde wiederholt, nur daß anstelle des dort verwendeten Emulgators Natriumdodecylhydrogensulfat als Emulgatorverwendetwurde. Hierdurch resultierte eine Öl-in-Wasser-Emulsion, welche in ihrem Auswaschverhalten der Emulsion des Beispiels 2 völlig unterlegen war: Nach jeweils zehnminütigem Auswaschen lag die Relieftiefe der photopolymerisierten Reliefschichten der photopolymerisierten flexographischen Reliefdruckplatten 1 gerade bei nur 100 µm, was völlig ungenügend war.

### Beispiel 3

Die Verwendung einer erfindungsgemäßen flüssigen Zusammensetzung für die Herstellung photopolymerisierter flexographischer Reliefdruckplatten 1

Beispiel 1 wurde wiederholt, nur daß der erfindungsgemäßen flüssigen Zusammensetzung noch 1 1 Limonen zugesetzt wurde. Während des Auswaschens konnte der störende Geruch des Alkohols nicht mehr länger wahrgenommen werden. Stattdessen trat ein angenehmer orangenartiger Geruch auf. Ansonsten wurden die bei Beispiel 1 im Detail beschriebenen Vorteile, welche sich aus der Verwendung der erfindungsgemäßen flüssigen Zusammensetzung des Beispiels 1 ergaben, allesamt auch hier erhalten.

### Beispiel 4

Die Verwendung einer erfindungsgemäßen flüssigen Zusammensetzung für die Herstellung photopolymerisierter flexographischer Reliefdruckplatten 1

Es wurde wie in Beispiel 3 verfahren, nur daß anstelle von n-Butanol n-Pentanol verwendet wurde. Der Flammpunkt der erfindungsgemäßen flüssigen Zusammensetzung nach DIN 51 755 lag bei 47°C, so daß für den Trommelwascher keine Explosionsschutzausrüstung notwendig wurde. Während der Entwicklung wurde ein angenehmer orangenartiger Geruch wahrgenommen. Die gebrauchte erfindungsgemäße flüssige Zusammensetzung konnte durch Destillation unter Normaldruck zu 90 % wiedergewonnen werden.

Die photopolymerisierten Reliefschichten der in dieser Weise erhaltenen photopolymerisierten flexographischen Reliefdruckplatten 1 wiesen eine Relieftiefe von 900 µm und eine vorzügliche, gleichmäßig matte, tropfnasenfreie druckende Oberfläche auf. Beim Drucken in einem Flexodruckwerk wurden in hoher Auflage Druckerzeugnisse erhalten, die in ihrer Wiedergabequalität den Druckerzeugnissen der Vergleichsversuche 1 bis 3 deutlich überlegen waren.

### Beispiel 5

Die Verwendung einer erfindungsgemäßen flüssigen Zusammensetzung für die Herstellung photopolymerisierter flexographischer Reliefdruckplatten 2

Beispiel 4 wurde wiederholt, nur daß anstelle der dort verwendeten flexographischen Reliefdruckplatten 1 Reliefdruckplatten 2 verwendet wurden. Bei den flexographischen Reliefdruckplatten 2 war die maximal erreichbare Relieftiefe der photopolymerisierten Reliefschichten bedingt durch den Plattenaufbau auf 700 µm festgelegt. Diese maximale Relieftiefe wurde bereits nach einer Auswaschzeit von nur 7 Minuten erreicht. Die in dieser Weise hergestellten photopolymerisierten Reliefschichten der photopolymerisierten flexographischen Reliefdruckplatten 2 waren von vorzüglicher Qualität und wiesen eine hervorragende gleichmäßig matte Oberfläche ohne Tropfnasen oder Orangenhaut auf. Beim Drucken auf einem Flexodruckwerk wurden exzellente Druckerzeugnisse in besonders hoher Auflage erhalten.

### Beispiel 6

Die Verwendung einer erfindungsgemäßen flüssigen Zusammensetzung für die Herstellung photopolymerisierter flexographischer Reliefdruckplatten 3

Beispiel 1 wurde wiederholt, nur daß anstelle der dort verwendeten flexographischen Reliefdruckplatte 1 und der dort verwendeten erfindungsgemäßen flüssigen Zusammensetzung die flexographische Reliefdruckplatte 3 und die erfindungsgemäße flüssige Zusammensetzung aus 34 I Tetrachlorethylen, 6 I n-Butanol und 20 1 Wasser verwendet wurden. Die maximale Relieftiefewurde bereits nach 7 Minuten erhalten. Während des Auswaschens waren der unangenehm süßliche Geruch des Tetrachlorethylens und der störende Geruch des n-Butanols bei weitem nicht mehr in dem störenden Ausmaß wahrzunehmen, wie dies etwa bei dem Vergleichsversuch 1 der Fall war. Desgleichen war die Emission des Tetrachlorethylens deutlich geringer als bei dem Vergleichsversuch 1 und lag unterhalb der allgemein gültigen strengen Emissionsgrenzwerte für Tetrachlorethylen.

Es wurden photopolymerisierte flexographischen Reliefdruckplatten 3 erhalten, deren photopolymerisierte Reliefschichten eine gleichmäßig matte Oberfläche ohne Tropfnasen oder Orangenhaut aufwiesen. Die photopolymerisierten flexographischen Reliefdruckplatten 3 waren hervorragend für den Flexoendlosdruck geeignet.

### Vergleichsversuch 4

Die Verwendung einer nicht erfindungsgemäßen flüssigen Zusammensetzung für die Herstellung photopolymerisierter flexographischer Reliefdruckplatten 2

Vergleichsversuch 1 wurde wiederholt, nur daß anstelle der dort verwendeten flexographischen Reliefdruckplatten 1 die Reliefdruckplatten 2 verwendet wurden. Auch bei diesem Vergleichsversuch traten die bei dem Vergleichsversuch 1 geschilderten, mit der Verwendung der nicht erfindungsgemäßen flüssigen Zusammensetzung verbundenen Nachteile auf.

Zwar konnte die maximale Relieftiefe der photopolymerisierten Reliefschichten bereits nach einer Auswaschzeit von 7 Minuten erreicht werden, indes wies die Oberfläche der photopolymerisierten Reliefschichten würmchenförmige Strukturen und Runzeln (Orangenhaut) auf.

### Beispiel 7

Die Verwendung einer erfindungsgemäßen flüssigen Zusammensetzung für die Herstellung photopolymerisierter flexographischer Reliefdruckplatten 3

Beispiel 1 wurde mit flexographischen Reliefdruckplatten 3 wiederholt. Auch hierbei traten die bei Beispiel 1 ausführlich beschriebenen, mit der Verwendung der flüssigen Zusammensetzung verbundenen Vorteile offen zu Tage, und es wurden photopolymerisierte flexographische Reliefdruckplatten 3 erhalten, deren photopolymerisierte Reliefschichten eine hervorragende gleichmäßig matte druckende Oberfläche ohne Tropfnasen und Orangenhaut aufwiesen. Beim Drucken auf einem Flexodruckwerk lieferten die in dieser Weise erhaltenen photopolymerisierten flexographischen Reliefdruckplatten 3 exzellente Druckerzeugnisse in besonders hoher Auflage.

## Patentansprüche

1. Verfahren zur Herstellung einer flexographischen Reliefdruckplatte, deren photopolymerisierte Reliefschicht eine einwandfreie druckende Oberfläche hat, durch
(a) bildmäßige Belichtung ihrer photopolymerisierbaren reliefbildenden Aufzeichnungsschicht, welche mindestens ein in organischen Lösungsmitteln lösliches oder quellbares Elastomer als Bindemittel, mindestens ein olefinisch ungesättigtes photopolymerisierbares Monomeres, das mit dem Elastomeren verträglich ist, und mindestens einen Photopolymerisationsinitiator enthält,
(b) Auswaschen (Entwickeln) der unbelichteten und daher nicht photopolymerisierten Bereiche der bildmäßig belichteten reliefbildenden Aufzeichnungsschicht mit einem Entwicklerlösungsmittel, wodurch die photopolymerisierte Reliefschicht resultiert,
dadurch gekennzeichnet, daß man hierbei als Entwicklerlösungsmittel eine Emulsion vom Typ "Wasser- in-Öl" verwendet, welche eine feindispergierte wäßrige Phase und eine kontinuierliche nicht brennbare oder schwer brennbare und/oder hochsiedende organische Phase im Volumenverhältnis von 90:10 bis 10:90 enthält.

2. Verfahren zur Herstellung einer photopolymerisierten flexographischen Reliefdruckplatte nach Anspruch 1, dadurch gekennzeichnet, daß das Volumenverhältnis bei 60:40 bis 40:60 liegt.

3. Verfahren zur Herstellung einer photopolymerisierten flexographischen Reliefdruckplatte nach Anspruch 1 oder 2, dadurch gekennzeichnet, daß die organische Phase chlorierte Kohlenwasserstoffe, aromatische Kohlenwasserstoffe, gesättigte und/oder ungesättigte cyclische und/oderacyclische Kohlenwasserstoffe, Petroleumdestillate, hydrierte Erdölfraktionen und/oder deren Gemische enthält oder hieraus besteht.

4. Verfahren zur Herstellung einer photopolymerisierten flexographischen Reliefdruckplatte nach einem der Ansprüche 1 bis 3, dadurch gekennzeichnet, daß die Wasser-in-Öl-Emulsion, bezogen auf ihre Gesamtmenge 0,1 bis 20 vol.% mindestens eines Alkohols enthält.

5. Verfahren zur Herstellung einer photopolymerisierten flexographischen Reliefdruckplatte nach einem der Ansprüche 1 bis 4, dadurch gekennzeichnet, daß die Wasser-in-Öl-Emulsion, bezogen auf ihre Gesamtmenge, 0,001 bis 10 vol.% mindestens einer oberflächenaktiven verbindung enthält.

6. Verfahren zur Herstellung einer photopolymerisierten flexographischen Reliefdruckplatte nach einem der Ansprüche 1 bis 5, dadurch gekennzeichnet, daß die organische Phase mindestens ein cyclisches Monoterpen enthält.

7. Verfahren zur Herstellung einer photopolymerisierten flexographischen Reliefdruckplatte nach einem der Ansprüche 1 bis 6, dadurch gekennzeichnet, daß die organische Phase mindestens eine hydrierte Erdölfraktion mit einem Flammpunkt >45_{°}C und einem Siedebereich oberhalb 160°C enthält.

## Claims

1. A process for the production of a flexographic rel ief printing plate whose photopolymerized relief layer has a satisfactory printing surface, by
(a) imagewise exposure of its photopolymerizable relief-forming recording layer which contains, as a binder, at least one elastomer which is soluble or swellable in organic solvents, at least one olefinically unsaturated photopolymerizable monomerwhich is compatible with the elastomer and at least one photopolymerization initiator, and
(b) washing out (development) of the unexposed and therefore nonphotopolymerized parts of the imagewise exposed, relief-forming recording layer with a developer, resulting in the photopolymerized relief layer,
wherein the developer used is an emulsion of the water-in-oil type which contains a finely dispersed aqueous phase and a continuous nonflammable or poorly flammable and/or high-boiling organic phase in a volume ratio of from 90 : 10 to 10 : 90.

2. A process for the production of a photopolymerized flexographic relief printing plate as claimed in claim 1, wherein the volume ratio is from 60 : 40 to 40 : 60.

3. A process for the production of a photopolymerized flexographic relief printing plate as claimed in claim 1 or 2, wherein the organic phase contains, or consists of, chlorohydrocarbons, aromatic hydrocarbons, saturated or unsaturated cyclic or acyclic hydrocarbons, petroleum distillates, hydrogenated mineral oil fractions or a mixture thereof.

4. A process for the production of a photopolymerized flexographic relief printing plate as claimed in any of claims 1 to 3, wherein the water-in-oil emulsion contains from 0.1 to 20% by volume, based on its total amount, of at least one alcohol.

5. A process for the production of a photopolymerized flexographic relief printing plate as claimed in any of claims 1 to 4, wherein the water-in-oil emulsion contains from 0.001 to 10% by volume, based on its total amount, of at least one surfactant compound.

6. A process for the production of a photopolymerized flexographic relief printing plate as claimed in any of claims 1 to 5, wherein the organic phase contains at least one cyclic monoterpene.

7. A process for the production of a photopolymerized flexographic relief printing plate as claimed in any of claims 1 to 6, wherein the organic phase contains at least one hydrogenated mineral oil fraction having a flashpoint of > 45°C and a boiling range above 160°C.

## Revendications

1. Procédé pour la préparation d'une plaque d'impression flexographique en relief dont la couche photopolymérisée en relief a une surface imprimante sans aucun défaut, par
(a) exposition à la lumière avec formation d'une image de la couche d'enregistrement photopolymérisable formant le relief, qui contient au moins un élastomère soluble ou gonflable dans les solvants organiques en tant que liants, au moins un monomère à insaturation oléfinique photopolymérisable compatible avec l'élastomère, et au moins un inducteur de photopolymérisation,
(b) lavage (développement) des régions non exposées et par conséquent non photopolymérisées de la couche d'enregistrement formant le relief exposée à la lumière avec formation d'une image à l'aide d'un solvant révélateur, ce qui donne la couche photopolymérisée en relief,
caractérisé en ce que l'on utilise à cet effet, en tant que solvant révélateur, une émulsion du type "eau- dans-l'huile" contenant une phase aqueuse en fine dispersion et une phase organique continue non inflammable ou difficilement inflammable et/ou à haut point d'ébullition, dans des proportions relatives de 90:10à10:90.

2. Procédé pour la fabrication d'une plaque d'impression flexographique photopolymérisée en relief selon la revendication 1, caractérisé en ce que les proportions relatives en volume sont de 60 : 40 à 40 : 60.

3. Procédé pour la fabrication d'une plaque d'impression flexographique photopolymérisée en relief selon la revendication 1 ou 2, caractérisé en ce que la phase organique consiste en totalité ou en partie en hydrocarbures chlorés, hydrocarbures aromatiques, hydrocarbures cycliques et/ou acycliques saturés et/ou insaturés, distillats de pétrole, fractions de pétrole hydrogénées et/ou leurs mélanges.

4. Procédé pour la fabrication d'une plaque d'impression flexographique photopolymérisée en relief selon une des revendications 1 à 3, caractérisé en ce que l'émulsion eau-dans-l'huile contient de 0,1 à 20 % de son volume total d'au moins un alcool.

5. Procédé pour la fabrication d'une plaque d'impression flexographique photopolymérisée en relief selon une des revendications 1 à 4, caractérisé en ce que l'émulsion eau-dans-l'huile contient de 0,001 à 10 % de son volume total d'au moins un composé tensioactif.

6. Procédé pour la fabrication d'une plaque d'impression flexographique photopolymérisée en relief selon une des revendications 1 à 5, caractérisé en ce que la phase organique contient au moins un monoterpène cyclique.

7. Procédé pour la fabrication d'une plaque d'impression flexographique photopolymérisée en relief selon une des revendications 1 à 6, caractérisé en ce que la phase organique contient au moins une fraction hydrogénée dont le point d'inflammation est supérieur à 45 degrés C et qui bout au-dessus de 160 degrés C.
